(19) **Europäisches Patentamt European Patent Office Office européen des brevets**

(11) **EP 2 930 739 B1**

(12) **EUROPEAN PATENT SPECIFICATION**

(45) Date of publication and mention of the grant of the patent:
**01.07.2020 Bulletin 2020/27**

(21) Application number: **12889660.2**

(22) Date of filing: **06.12.2012**

(51) Int Cl.:
*H01L 21/336* [(2006.01)]    *H01L 21/261* [(2006.01)]
*H01L 21/263* [(2006.01)]    *H01L 29/06* [(2006.01)]
*H01L 29/78* [(2006.01)]    *H01L 29/739* [(2006.01)]
*H01L 29/868* [(2006.01)]

(86) International application number:
**PCT/CN2012/085993**

(87) International publication number:
**WO 2014/086010 (12.06.2014 Gazette 2014/24)**

(54) **SUPER-JUNCTION MANUFACTURING METHOD**

HERSTELLUNGSVERFAHREN FÜR EINE SUPERVERBINDUNG

PROCÉDÉ DE FABRICATION D'UNE SUPER-JONCTION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**14.10.2015 Bulletin 2015/42**

(73) Proprietors:
• **Institute Of Microelectronics, Chinese Academy Of Sciences Beijing 100029 (CN)**
• **Jiangsu Cas-IGBT Technology Co., Ltd New District Wuxi Jiangsu 214135 (CN)**
• **Jiangsu R&D Center For Internet Of Things Wuxi, Jiangsu 214135 (CN)**

(72) Inventors:
• **ZHANG, Wenliang Beijing 100029 (CN)**
• **ZHU, Yangjun Beijing 100029 (CN)**
• **LU, Shuojin Beijing 100029 (CN)**
• **TIAN, Xiaoli Beijing 100029 (CN)**
• **CHU, Weili Beijing 100029 (CN)**

(74) Representative: **Nordmeyer, Philipp Werner df-mp Dörries Frank-Molnia & Pohlman Patentanwälte Rechtsanwälte PartG mbB Theatinerstraße 16 80333 München (DE)**

(56) References cited:
WO-A1-01/06557    CN-A- 1 036 049
CN-A- 102 254 828    US-A- 3 255 050
US-A- 4 135 951    US-A- 4 806 497
US-A- 4 910 156    US-A1- 2003 132 450
US-A1- 2005 082 542    US-B1- 6 475 864
US-B1- 6 703 292

• FINDLAY D J S ED - BRAUCHER RÉGIS ET AL: "APPLICATIONS OF PHOTONUCLEAR REACTIONS", NUCLEAR INSTRUMENTS & METHODS IN PHYSICS RESEARCH. SECTION B: BEAM INTERACTIONS WITH MATERIALS AND ATOMS, ELSEVIER BV, NL, vol. B50, no. 1/04, 3 April 1990 (1990-04-03), pages 314-320, XP000125151, ISSN: 0168-583X, DOI: 10.1016/0168-583X(90)90374-4
• ZABLOTSKII V V ET AL: "DOPING OF SEMICONDUCTORS BY PHOTONUCLEAR REACTIONS", SOVIET PHYSICS SEMICONDUCTORS, AMERICAN INSTITUTE OF PHYSICS. NEW YORK, US, vol. 20, no. 4, 1 April 1986 (1986-04-01), pages 397-399, XP000821622,

**(Cont. next page)**

- **FINDLAY D J S ET AL: "Photonuclear transmutation doping of semiconductors", SEMICONDUCTOR SCIENCE AND TECHNOLOGY, IOP PUBLISHING LTD, GB, vol. 3, no. 4, 1 April 1988 (1988-04-01), pages 388-396, XP020031753, ISSN: 0268-1242, DOI: 10.1088/0268-1242/3/4/018**

**Description**

BACKGROUND

After the proposing of the super-junction theory, withstand voltage of a semiconductor device adopting a super-junction is improved.

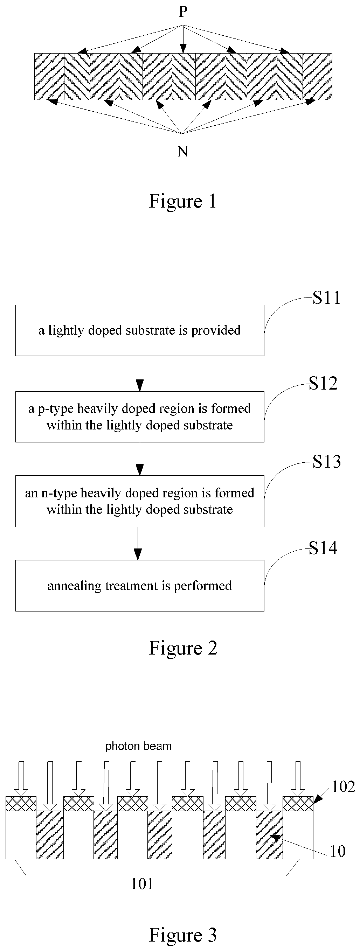

Essence of the super-junction theory is the charge balance principle or the charge complementary principle, where a traditional low-doped withstand voltage structure is replaced with alternately arranged p-n structures (as shown in Figure 1).

A traditional process for manufacturing a super-junction is an ion implantation process or a grooving and filling process. The ion implantation process mainly adopts a high energy ion implantation process or a repeated epitaxy and implantation process. The grooving and filling process mainly adopts a deep reactive ion etching process, or a repeated epitaxy, grooving and filling process.

Complexity in the above described methods for manufacturing a super-junction results in a high cost for manufacturing a super-junction.

International publication No. WO 01/06557 A1 discloses a method of manufacturing a charge compensation semiconductor device using neutron transmutation. A p-type silicon body having an acceptor doping concentration for the p-type regions of the semiconductor material is subjected to irradiation with collimated beams of thermal neutrons at window areas in a mask so as to form the n-type regions by transmutation of silicon atoms into phosphorus. A well-defined and controllable phosphorus doping concentration to balance the low acceptor concentration of the p-type regions is achievable in this manner, even when the acceptor concentration is of boron. The silicon body so formed is sliced and/or polished transverse to the p-n junctions so as to form a wafer for device manufacture.

Patent No. US 6475864B1 discloses a method for manufacturing a super-junction semiconductor device with a conductivity type layer. A surface MOSFET structure, including p-type base regions, a p+-type contact region in p-type base region, an n+-type source region in p-type base region, a gate electrode layer and a source electrode, is formed in the surface portion of an n-type semiconductor substrate through the usual double diffusion MOSFET manufacturing process. An oxide film is deposited by the CVD method on the back surface of the semiconductor substrate, a resist mask for defining p-type partition regions is formed on the oxide film, the oxide film is removed by ion etching, and trenches by selective epitaxial growth, and the remaining oxide film is removed. The portions of n-type semiconductor substrate not etched off remain as n-type drift regions, resulting in an alternating conductivity type layer formed of n-type drift regions and p-type partition regions. A drain electrode is deposited on the back surface of alternating conductivity type layer.

A reference (FINDLAY D J S ED-BRAUCHER REGIS ET AL: "APPLICATIONS OF PHOTONUCLEAR REACTIONS", NUCLEAR INSTRUMENTS & METHODS IN PHYSICS RESEARCH. SECTION B: BEAM INTERACTIONS WITH MATERIALS AND ATOMS, ELSEVIER BV, NL, vol. B50, no. 1/04, 3 April 1990 (1990-04-03), pages 314-320, XP000125151, ISSN:0168-583X, DOI:10.1016/0168-583X(90)90374-4.) discloses several applications of photonuclear reactions for a variety of purposes: photonuclear transmutation doping of semiconductors, neutron production from electron linacs, quality checking of radioactive waste, fission product incineration, photoexcitation of isomers for dosimetry, and nuclear resonance fluorescence for materials analysis.

SUMMARY

To address the above technical problem, a method for manufacturing a super-junction is provided according to embodiments of the present disclosure, in order to simplify a manufacturing process of a super-junction and reduce the manufacture cost.

A method for manufacturing a super-junction is provided, which includes:

providing a lightly doped substrate; forming a p-type heavily doped region within the lightly doped substrate through a transmutation doping process by taking a first mask with a pattern of the p-type heavily doped region; forming an n-type heavily doped region within the lightly doped substrate through a transmutation doping process by taking a second mask with a pattern of the n-type heavily doped region; and performing annealing treatment.

Preferably, the lightly doped substrate may be made of silicon, silicon carbide, gallium arsenide, or indium antimonide. According to the present invention, the forming a p-type heavily doped region within the lightly doped substrate through a transmutation doping process includes : forming a high-energy photon beam by using a photon source; and forming a p-type heavily doped region within the lightly doped substrate by a nuclear reaction started by particle radiation on the lightly doped substrate by using the high-energy photon beam. The photon source may be an electronic linear accelerator photon source. The energy of the high-energy photon beam may range from 17.5 MeV to 22.5 MeV. The first mask may be made of high-energy photon absorber. The forming an n-type heavily doped region within the lightly doped substrate through a transmutation doping process may include: forming a neutron beam by using a neutron source; and forming an n-type heavily doped region within the lightly doped substrate by a nuclear reaction started by particle radiation on the lightly doped substrate by using the neutron beam. The neutron source may be a radioisotope neutron source, an accelerator neutron source, or a reactor neutron source. The second mask may be made of neutron absorber.

A method for manufacturing a super-junction is provided, which includes:

providing a first-type heavily doped substrate; forming a second-type heavily doped region within the first-type heavily doped substrate through a transmutation doping process by taking a third mask with a pattern of the second-type heavily doped region, wherein a region except for the second-type heavily doped region is a first-type heavily doped region; and performing annealing treatment.

Preferably, the first-type heavily doped substrate may be a p-type heavily doped substrate, and the second second-type heavily doped region may be an n-type heavily doped region. The first-type heavily doped substrate may be made of silicon, silicon carbide, gallium arsenide, or indium antimonide. The forming a second-type heavily doped region within the first-type heavily doped substrate through a transmutation doping process may include: forming a neutron beam by using a neutron source; and forming a second-type heavily doped region within the first-type heavily doped substrate by a nuclear reaction started by particle radiation on the first-type heavily doped substrate by using the neutron beam to ignite.

According to the present invention, the first-type heavily doped substrate is an n-type heavily doped substrate, and the second-type heavily doped region is a p-type heavily doped region. The first-type heavily doped substrate may be made of silicon, silicon carbide, diamond, germanium, gallium arsenide, or indium antimonide. The forming a second-type heavily doped region within the first-type heavily doped substrate through a transmutation doping process includes : forming a high-energy photon beam by using a photon source; and forming a second-type heavily doped region within the first-type heavily doped substrate by a nuclear reaction started by particle radiation on the first-type heavily doped substrate by using the high-energy photon beam.

Preferably, the first-type heavily doped substrate may be made of germanium. The forming a second-type heavily doped region within the first-type heavily doped substrate through a transmutation doping process may include: forming a neutron beam by using a neutron source; and forming a second-type heavily doped region within the first-type heavily doped substrate by a nuclear reaction started by particle radiation on the first-type heavily doped substrate by using the neutron beam.

A super-junction manufactured by any one of the methods described above is provided.

A super-junction semiconductor device is provided, where a super-junction in the super-junction semiconductor device is the super-junction described above.

The technical solution described above has the following advantages over the prior art.

In the technical solutions according to the embodiments of the present disclosure, a p-type heavily doped region and an n-type heavily doped region are formed within a lightly doped substrate through a transmutation doping process. Or, a second-type heavily doped region is formed within the first-type heavily doped substrate through a transmutation doping process. In the transmutation doping process, a doped region within a substrate is obtained by a nuclear reaction, i.e., a super-junction can be obtained by only particle radiation and annealing treatment. While a super-junction in the prior art is obtained by a repeated epitaxy and implantation process or a repeated epitaxy, grooving and filling process. Therefore, in comparison with the prior art, the manufacturing process is simplified and the manufacture cost is reduced with the method for manufacturing a super-junction provided in the present disclosure.

## BRIEF DESCRIPTION OF THE DRAWINGS

Figure 1 is a schematic diagram of an existing super-junction;
Figure 2 is a schematic flowchart of a method for manufacturing a super-junction according to an embodiment of the present disclosure;
Figure 3 and Figure 4 are each a schematic flowchart of a doping process for a super-junction according to another embodiment of the present disclosure;
Figure 5 is a schematic flowchart of another method for manufacturing a super-junction according to another embodiment of the present disclosure; and
Figure 6 is a schematic flowchart of a doping process for a super-junction according to yet another embodiment of the present disclosure.

## DETAILED DESCRIPTION

For clarity of the above objects, features and advantages of the disclosure, the embodiments of the disclosure will be described in detail in conjunction with the drawings.

To facilitate sufficient understanding of the disclosure, details are explained in the following descriptions. However the present disclosure may be implemented in other ways different from those described herein, and similar extensions can be made by those skilled in the art without deviating from the essence of the present disclosure. Therefore the present disclosure is not limited to the embodiments described hereinafter.

First embodiment useful to understand the present invention

A method for manufacturing a super-junction is disclosed in this embodiment, as shown in Figure 2. The method includes the following steps S11 to S14.

In step S11, a lightly doped substrate is provided. The lightly doped substrate is an n-type lightly doped substrate, a p-type lightly doped substrate, or a lightly doped substrate close to an intrinsic semiconductor. The lightly doped substrate is made of material for manufacturing a semiconductor device, such as silicon, silicon carbide, gallium arsenide, indium antimonide.

In step S12, a p-type heavily doped region is formed within the lightly doped substrate through a transmutation doping process by taking a first mask with a pattern of the p-type heavily doped region.

In step S13, an n-type heavily doped region is formed within the lightly doped substrate through a transmutation doping process by taking a second mask with a pattern of the n-type heavily doped region.

The p-type heavily doped region and the n-type heavily doped region are arranged alternately within the lightly doped substrate. Front surfaces of the p-type heavily doped region and the n-type heavily doped region are aligned with a front surface of the lightly doped substrate, and back surfaces of the p-type heavily doped region and the n-type heavily doped region are aligned with a back surface of the lightly doped substrate.

In step S14, annealing treatment is performed to restore electrical properties of the lightly doped substrate. The temperature for the annealing treatment ranges from 800 Celsius degree to 900 Celsius degree.

In the transmutation doping process, a doped region within a substrate is obtained by a nuclear reaction, i.e., a super-junction can be obtained by only particle radiation and annealing treatment. While a super-junction in the prior art is obtained by a repeated epitaxy and implantation process or a repeated epitaxy, grooving and filling process. Therefore, in comparison with the prior art, the manufacturing process is simplified and the manufacture cost is reduced with the method for manufacturing a super-junction provided in the present disclosure.

Furthermore, the particle beam adopted in the transmutation doping process has strong penetrability, and can be applied to a thick substrate. Therefore, the super-junction formed by the method according to this embodiment is applicable to various semiconductor devices with various withstand voltages. In addition, a path of the particles in the lightly doped substrate is almost a straight line, and thus almost uniform doping is formed in well-defined regions within the lightly doped substrate, and a doping concentration can be precisely controlled.

It should be noted that, orders of step S12 and step S13 are interchangeable in this embodiment.

Second embodiment according to the present invention

Another method for manufacturing a super-junction is disclosed in this embodiment. The method includes the following steps S21 to S24.

In step S21, a lightly doped substrate is provided. The lightly doped substrate is an n-type lightly doped substrate, a p-type lightly doped substrate, or a lightly doped substrate close to an intrinsic semiconductor. The lightly doped substrate is made of material for manufacturing a semiconductor device, such as silicon, silicon carbide, gallium arsenide, indium antimonide.

In step S22, a p-type heavily doped region is formed within the lightly doped substrate. Step S22 includes the following steps S221 and S222.

In step S221, a high-energy photon beam is formed by using a photon source.

Since the high-energy photon beam may be generated by bremsstrahlung from an electronic linear accelerator, the photon source in this embodiment is preferably an electronic linear accelerator photon source. And the energy of the generated high-energy photon beam is between 17.5 MeV and 22.5 MeV.

In order to achieve local doping, the photons in the photon beam generated by the photon source need to move in directions parallel to each other. That is, the photon beam is similar to parallel light, or the photon beam has at least certain parallelism.

In step S222, a p-type heavily doped region is formed within the lightly doped substrate by a nuclear reaction started by particle radiation on the lightly doped substrate by using the neutron beam.

In the method described above, the material is doped by photon radiation.

An attenuation coefficient of high-energy electrons in silicon is very small, so it is possible to achieve deep doping in semiconductor. And the distribution of isotopic atoms in the crystal is very uniform, and thus very uniform doping is formed through transmutation of an element beam, by particle radiation on the lightly doped substrate by using the high-energy photon.

Furthermore, as for the lightly doped substrate made of silicon, a p-type impurity may be formed by a nuclear reaction started by the radiation of the high-energy photon beam.

That is, silicon-30 is transmuted into aluminum-27 and releases one proton after absorbing one photon, and specifically the nuclear reaction is:

$$\,^{28}_{14}\mathrm{Si}(\gamma,\mathrm{p})\,^{27}_{13}\mathrm{Al}$$

Or, silicon-30 is transmuted into silicon-27 and releases one neutron after absorbing one photon, and then the silicon-27 is transmuted into aluminum-27 by releasing a positron after a half-life of 4.2s. The nuclear reaction is:

$$\,^{28}_{14}\mathrm{Si}(\gamma,\mathrm{n})\,^{27}_{13}\mathrm{Si}\xrightarrow{\;4.2\mathrm{s},\;\;\beta^{+}\;}\,^{27}_{13}\mathrm{Al}$$

The stable A1 generated according to this reaction is just the donor element for p-doped silicon.

Although a threshold value of photon energy for the nuclear reaction is 11.6 MeV, Huge resonance produces a maximum photon capture cross section when the photon energy is between 17.5 MeV and 22.5 MeV. Therefore, for example, photon energy in the high energy photon beam according to the present embodiment is between 17.5 MeV and 22.5MeV, preferably 20 MeV

As for a lightly doped substrate made of silicon carbide, a p-type impurity may be formed by a nuclear reaction started by radiation of the high-energy photon beam on the lightly doped substrate.

That is, after absorbing one photon, a carbon-12 is transmuted into a boron-11 and releases one proton, and the nuclear reaction is:

$$^{12}_{6}C(\gamma, p)\,^{11}_{5}B$$

Alternatively, a carbon-12 is transmuted into a carbon-11 and release one proton after absorbing one photon, and then the carbon-11 is transmuted into a boron-11 by releasing one positron. Specifically the nuclear reaction is:

$$^{12}_{6}C(\gamma, p)\,^{11}_{6}C \xrightarrow{\beta^+} \,^{11}_{5}B$$

A nuclear reaction process of silicon in silicon carbide is the same as the reaction of the silicon described above.

Furthermore, as for the lightly doped substrate made of gallium arsenide or indium antimonide, a p-type impurity may be formed by a nuclear reaction after the lightly doped substrate is radiated by the high-energy photon beam.

Since in the particle irradiation process a local transmutation doping is achieved by using a high-energy photon beam, a first mask used for forming the p-type heavily doped region is made of photon absorber to block unwanted particle radiation.

The high-energy photon absorber includes at least one of an elementary substance or compound of heavy metal, a titanate or silane coupling agent, and other substances capable of effectively absorbing photons.

In step S23, an n-type heavily doped region is formed within the lightly doped substrate. Step S23 includes the following steps S231 and S232.

In step S231, a neutron source is provided to form a neutron beam.

A free neutron may decay into a proton and release an electron and an anti-electric neutrino because the free neutron is unstable, an average life of the free neutron is only 15 minutes, and thus it can't be stored for a long term. Therefore, an appropriate source for generating neutrons is required to supply neutrons. The neutron sources are classified into the following three types:

1st: Radioisotope neutron source. The radioisotope neutron source includes: a ($\alpha$, n) neutron source, which is obtained by employing a nuclear reaction 9Be+$\alpha$→12C+n+5.701 MeV by the following steps: $^{238}$Pu, $^{226}$Ra or $^{241}$Am irradiating $\alpha$ rays are mixed uniformly with a beryllium metal powder at a certain percentage, and then the mixture is pressed into a small cylinder and sealed in a metal case; and a ($\gamma$, n) neutron source, which generates neutrons by $\gamma$ rays irradiated through a nuclear reaction, including a $^{24}$Na-Be source, a $^{124}$Sb-Be source and the like. The radioisotope neutron source can be simply manufactured into a smaller volume and can be used conveniently.

2nd: Accelerator neutron source. The accelerator neutron source generates neutrons through a nuclear reaction by using charged particles accelerated by the accelerator to bombard an appropriate target nucleus. The most common nuclear reactions include (d, n), (p, n), ($\gamma$, n), and the like. An neutron intensity generated by the accelerator neutron source is much larger than that of the radioisotope neutron source, and monoenergetic neutrons can be obtained in a wide energy range through the accelerator neutron source. Moreover, pulse neutrons may be obtained if the accelerator is pulse modulated.

3rd, Reactor neutron sources. The reactor neutron source generates lots of neutrons by using an atomic nucleus fission reactor. Reactor is the strongest thermal neutron source. Neutrons may be led out by opening a hole in a wall of the reactor, and the energy of the obtained neutrons is in continuous distribution, which is similar to Maxwell distribution. Neutron beams with various energies can be obtained by taking certain measures.

Of course, like the requirement for the photon beam, the neutrons in the neutron beam also need to move in directions parallel to each other. The neutrons beam has at least certain parallelism.

In step S232, an n-type heavily doped region is formed within the lightly doped substrate by a nuclear reaction started by particleradiation on the lightly doped substrate with the neutron beam.

In the method described above, the material is doped by neutron radiation. The distribution of isotopic atoms in the crystal is very uniform and a penetration depth of the neutron in a semiconductor is very large (about 100 cm), and thus very uniform doping is formed through transmutation of the element by particle radiation on the lightly doped substrate with the neutron beam. This is very useful for the manufacture of a high-power semiconductor device and a radiation detecting device.

In addition, as for the lightly doped substrate made of silicon, an n-type impurity may be formed by a nuclear reaction started after the lightly doped substrate is radiated by the neutron beam. That is, after absorbing one neutron, a silicon-30 is transmuted into a silicon-31 and releases one photon, and then after a half-life of 2.6 h, the silicon-31 is transmuted into a phosphorus-31 by releasing an electron . The nuclear reaction is:

$$^{30}_{14}Si\left(n, \gamma\right)^{31}_{14}Si \xrightarrow{2.6h, \beta^-} \,^{31}_{15}P$$

The stable P generated by the reaction is just the donor element for n-type doped silicon.

The concentration $N_D$ (in cm$^{-3}$) of P achieved after the radiation is performed can be calculated using the following formula:

$$N_D = N_{Si30}\,\sigma\psi t$$

Where, $N_{Si30}$ (in cm$^{-3}$) is abundance of $^{30}$Si; $\sigma$ is a radiative capture cross section of a Si atom with respect to a thermal neutron ($\sigma$ =0.11 barn); $\psi$ (in cm$^{-2}$s$^{-1}$) is a radiation dose of thermal neutrons , and t (in s) is radiation time duration.

Since the abundance of $^{30}$Si, $N_{Si30}$, is constant in a lightly doped substrate, and the radiative capture cross section $\sigma$ of a Si atom with respect to a thermal neutron is also constant, the doped impurity concentration in the n-type silicon can be precisely controlled by adjusting the radiation dose $\psi$ of thermal neutrons and the radiation time duration t. Moreover, only one element (**P**) is generated in the reaction above, and no compensation due to transmutation occures.

In addition, $^{30}$Si has a natural uniform distribution in silicon, and thus $^{31}$P generated through transmutation is also in a uniform distribution, i.e., the impurity in the N-type silicon is in a uniform distribution.

In addition, to avoid the influence of an ununiform distribution of the neutron beam flux, a metal flux homogenizer can be used to obtain a uniform distribution of the neutron beam flux.

As for a lightly doped substrate made of silicon carbide, like the lightly doped substrate made of silicon, when the lightly doped substrate is radiated with a neutron beam, after absorbing one neutron, a silicon-30 is transmuted into a silicon-31 and releases one photon, and after a half-life of 2.6h, the silicon-31 is transmuted into a phosphorus-31 by releasing a electron. Therefore the donor element phosphorus appears in the silicon carbide, and thus the silicon carbide becomes n-type doped silicon carbide.

In addition, as for a lightly doped substrate made of gallium arsenide or indium antimonide, when being radiated with a neutron beam, an n-type impurity can be generated by a nuclear reaction.

Because the particle radiation process described above achieves a local transmutation doping using the neutron beam, a second mask for forming an n-type heavily doped region is made of neutron absorber to block the unwanted particle radiation.

Effective neutron absorber is a radioisotope capable of generating a stable atom nucleus by absorbing one neutron. For example, a xenon-135 (a half-life of is about 9.1 hours) can be transmuted into a stable xenon-136 by absorbing one neutron. In a nuclear reactor by nuclear fissions of uranium-235, uranium-233 and plutonium-239, and the iodine-135 can generate xenon-135 by decaying rapidly and releasing a $\beta$ particle (a high energy electron). Therefore, the neutron absorber may be at least one of the above isotopes.

Other neutron absorber mainly includes: helium-3 isotope, which can generate a tritium (a heavy isotope of hydrogen) after absorbing a neutron; boron-10, which can generate a lithium and a helium nucleus after absorbing a neutron; and samarium-149, which is also effective neutron absorber and can generate a stable samarium-150 isotopes after absorbing a neutron.

In addition, some neutron absorbers used for control rods in nuclear reactors include cadmium, hafnium and rare earth metal gadolinium. These neutron absorbers contain several isotopes, and some are very effective neutron absorber.

All these materials described above may be used as neutron absorbers in this embodiment, i.e., can be used for making the second mask. Furthermore, the second mask made of a selected suitable material and having sufficient thickness can effectively absorb neutrons to function as a mask and to achieve local doping.

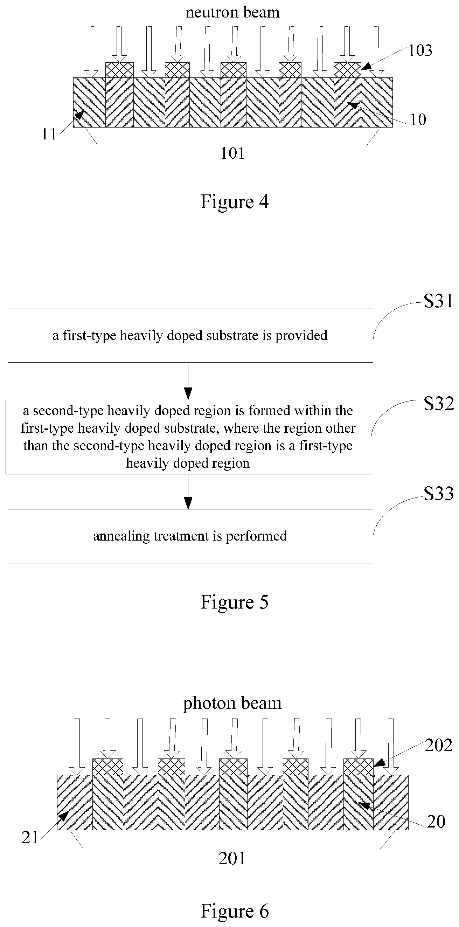

In addition, for ease of understanding, Figure 3 and Figure 4 each shows a doping process described above.

As shown in Figure 3, a lightly doped substrate 101 is covered with a first mask 102 with a pattern of the p-type heavily doped region, and the first mask 102 and the lightly doped substrate 101 are aligned with each other. After that, the lightly doped substrate 101 is radiated with a high-energy photon beam in an incident direction perpendicular to a surface of the lightly doped substrate 101. In a position sheltered by the first mask 102, the high-energy photon beam is absorbed by the first mask 102. While in a position of the lightly doped substrate 101 unsheltered by the first mask 102, the high-energy photon beam can be injected directly into the lightly doped substrate 101 and starts a nuclear reaction (for example, silicon is transmuted into aluminum), to obtain a p-type heavily doped region 10.

As shown in Figure 4, a lightly doped substrate 101 is covered and aligned with a second mask 103 with a pattern of the n-type heavily doped region. After that, the lightly doped substrate 101 is radiated with a neutron beam in an incident direction perpendicular to a surface of the lightly doped substrate 101. In a position of the lightly doped substrate 101 sheltered by the second mask 103, the neutron beam is absorbed by the second mask 103. While in a position of the lightly doped substrate 101 unsheltered by the second mask 103, the neutron beam can be injected directly into the lightly doped substrate 101 and starts a nuclear reaction (for example, silicon is transmuted into phosphor), to obtain an n-type heavily doped region 11.

The p-type heavily doped region 10 and the n-type heavily doped region 11 are arranged alternately within the lightly doped substrate 101. Front surfaces of the p-type heavily doped region 10 and the n-type heavily doped region 11 are aligned with a front surface of the lightly doped substrate 101, and back surfaces of the p-type heavily doped region 10 and the n-type heavily doped region 11 are aligned with a back surface of the lightly doped substrate 101.

In step S24, annealing treatment is performed.

Defects may be caused in the lightly doped substrate by the radiation in the above-described method, and the lightly doped substrate significantly changes in physical properties. Thus, a annealing treatment on the lightly doped substrate is required in order to restore electrical properties of the lightly doped substrate, wherein the annealing temperature ranges preferably from 800 Celsius degree to 900 Celsius degree.

In the technical solutions according to the embodiment of the present disclosure, a p-type heavily doped region and an n-type heavily doped region are formed within the lightly doped substrate through a transmutation doping process. In the transmutation doping process, a doped region within a substrate is obtained by a nuclear reaction, i.e., a super-junction can be obtained by only particle radiation and annealing treatment. While a super-junction in the prior art is obtained by a repeated epitaxy and implantation process or a repeated epitaxy, grooving and filling process. Therefore, in comparison with the prior art, the manufacturing process is simplified and the manufacture cost is reduced with the method for manufacturing a super-junction provided in the present disclosure.

Furthermore, particles adopted in the transmutation doping process have strong penetrability, and thus the transmutation doping process may be applied to a thick substrate. The super-junction formed by the method according to this embodiment is applicable to various semiconductor devices with various withstand voltages. In addition, the path of the particles in the lightly doped substrate is almost a straight line, and thus almost a uniform distribution is formed in a well-defined doping region within the lightly doped substrate, and a doping concentration can be precisely controlled.

It should be noted that, the orders of step S22 and step S23 are interchangeable in this embodiment.

Third embodiment useful to understand the present invention

Still another method for manufacturing a super-junction is disclosed in this embodiment. As shown in Figure 5, the method includes the following steps S31 to S33.

In step S31, a first-type heavily doped substrate is provided. The first-type heavily doped substrate is an n-type heavily doped substrate according to the present invention or a p-type heavily doped substrate in an embodiment useful to understand the present invention.

In step S32, by taking a third mask with a pattern of the second-type heavily doped region, a second-type heavily doped region is formed within the first-type heavily doped substrate through a transmutation doping process, where a region other than the second-type heavily doped region is a first-type heavily doped region.

Specifically, the first-type heavily doped region and the second-type heavily doped region are arranged alternately.

In step S33, annealing treatment is performed to restore electrical properties of the first-type heavily doped substrate. The temperature for the annealing treatment is between 800 Celsius degree to 900 Celsius degree.

In this embodiment, the second-type heavily doped region is formed within the first-type heavily doped substrate through a transmutation doping process. In the transmutation doping process, a doped region within a substrate is obtained by a nuclear reaction, i.e., a super-junction can be obtained by only particle radiation and annealing treatment. While a super-junction in the prior art is obtained by a repeated epitaxy and implantation process or a repeated epitaxy, grooving and filling process. Therefore, in comparison with the prior art, the manufacturing process is simplified and the manufacture cost is reduced with the method for manufacturing a super-junction provided in the present disclosure.

Furthermore, particles adopted in the transmutation doping process have strong penetrability, and thus the transmutation doping process may be applied to a thick substrate. and the super-junction formed by the method according to this embodiment is applicable to various semiconductor devices with various withstand voltages. In addition, the path of the particles in the lightly doped substrate is almost a straight line, and thus almost a uniform distribution is formed in a well-defined doping region within the lightly doped substrate, and a doping concentration can be precisely controlled.

In addition, as compared with the previous embodiments, the method for manufacturing a super-junction according to this embodiment is further simplified and the manufacture cost is further reduced.

Fourth embodiment not forming part of the present invention

Still another method for manufacturing a super-junction is disclosed in this embodiment. The method includes the following steps S41 to S43.

In step S41, a first-type heavily doped substrate is provided. The first-type heavily doped substrate is a p-type heavily doped substrate. The first-type heavily doped substrate is made of material for manufacturing a semiconductor device, such as silicon, silicon carbide, gallium arsenide, indium antimonide which can be used for manufacturing a semiconductor device.

In step S42, a second-type heavily doped region is formed within the first-type heavily doped substrate, wherein a region other than the second-type heavily doped region is a first-type heavily doped region. The second-type heavily doped region is an n-type heavily doped region. Since the first-type heavily doped region is of the same type as the first-type heavily doped substrate, the first-type heavily doped region is a p-type heavily doped region.

Step S42 includes the following steps S421 and S422.

In step S421, a neutron source is provided to form a neutron beam.

In step S422, n-type impurity is formed within the first-type heavily doped substrate a nuclear reaction started by particle radiation on the first-type heavily doped substrate with the neutron beam, so as to obtain a second-type heavily doped region.

In the method described above, since a local transmutation doping is performed on the material by using neutron radiation, a third mask with a pattern of the second-type heavily doped region is required, and the third mask is made of neutron absorber.

In step S43, annealing treatment is performed to restore electrical properties of the first-type heavily doped substrate. The temperature for the annealing treatment is between 800 Celsius degree and 900 Celsius degree.

Fifth embodiment according to the present invention

Yet another method for manufacturing a super-junction is disclosed in this embodiment. The method includes the following steps S51 to S53.

In step S51, a first-type heavily doped substrate is provided. The first-type heavily doped substrate is an n-type heavily doped substrate. The first-type heavily doped substrate is made of material such as silicon, silicon carbide, diamond, germanium, gallium arsenide, indium antimonide, which can be used for manufacturing a semiconductor device.

In step S52, a second-type heavily doped region is formed within the first-type heavily doped substrate, wherein a region other than the second-type heavily doped region is a first-type heavily doped region. The second-type heavily doped region is a p-type heavily doped region. Since the first-type heavily doped region has the same type as the first-type heavily doped substrate, the first-type heavily doped region is an n-type heavily doped region.

Step S52 includes the following steps S521 and S522.

In step S521, a photon source is provided to form a high-energy photon beam.

In step S522, a p-type impurity is formed within the first-type heavily doped substrate by a nuclear reaction started by particle radiation on the first-type heavily doped substrate with the high-energy photon beam, so as to obtain a second-type heavily doped region.

As for the first-type heavily doped substrate made of diamond, a p-type impurity may also be formed by a nuclear reaction after the first-type heavily doped substrate is irradiated by the high-energy photon beam.

That is, after absorbing one photon, a carbon-12 is transmuted into a boron-11 and release one proton, and the nuclear reaction is:

$$^{12}_{6}C(\gamma, p)^{11}_{5}B$$

Or, after absorbing one photon, a carbon-12 is transmuted into a carbon-11 and releases one proton, and then the carbon-11 is transmuted into a boron-11 by releasing one positron. The nuclear reaction is:

$$^{12}_{6}C(\gamma, p)^{11}_{6}C \xrightarrow{\beta^{+}} {}^{11}_{5}B$$

In the method described above, since a local transmutation doping is performed on the material by using photon irradiation, a third mask with a pattern of the second-type heavily doped region is required, and the third mask is made of a high-energy photon absorber.

For ease of understanding, Figures 6 shows a doping process described above.

A first-type heavily doped substrate 201 is covered and aligned with a third mask 202 with a pattern of the second-type heavily doped region. After that, the first-type heavily doped substrate 201 is radiated with a high-energy photon beam in an incident direction perpendicular to a surface of the first-type heavily doped substrate 201. In a position of the first-type heavily doped substrate 201 sheltered by the third mask 202, the high-energy photon beam is absorbed by the third mask 202. While in a position of the first-type heavily doped substrate 201 unsheltered by the third mask 202, the high-energy photon beam can be injected directly into the first-type heavily doped substrate 201 and starts a nuclear reaction (for example, a carbon is transmuted into a boron), to obtain a second-type heavily doped region 21. A region other than the second-type heavily doped region 21 is a first-type heavily doped region 20.

In step S53, annealing treatment is performed to restore electrical properties of the first-type heavily doped substrate. The temperature for the annealing treatment is between 800 Celsius degree and 900 Celsius degree.

Sixth embodiment not forming part of the present invention

Still yet another method for manufacturing a super-junction is disclosed in this embodiment. The method includes the following steps S61 to S63.

In step S61, a first-type heavily doped substrate is provided. The first-type heavily doped substrate is an n-type heavily doped substrate and made of a germanium.

In step S62, a second-type heavily doped region is formed within the first-type heavily doped substrate, wherein a region other than the second-type heavily doped region is a first-type heavily doped region. The second-type heavily doped region is a p-type heavily doped region. Since the first-type heavily doped region is of the same type as the first-type heavily doped substrate, the first-type heavily doped region is an n-type heavily doped region.

Step S62 includes the following steps S621 and S622.

In step S621, a neutron source is provided to form a neutron beam.

In step S622, a p-type impurity is formed within the first-type heavily doped substrate a nuclear reaction started by particle radiation on the first-type heavily doped substrate with the neutron beam, so as to obtain a second-type heavily doped region.

In the method described above, since a local transmutation doping is performed on the material by using neutron radiation, a third mask with a pattern of the second-type heavily doped region is required, and the third mask is made of a neutron absorber.

In step S63, annealing treatment is performed to restore electrical properties of the first-type heavily doped substrate. The temperature for the annealing treatment is between 800 Celsius degree to 900 Celsius degree.

Seventh embodiment

A super-junction is disclosed in this embodiment, which is formed by the method according to any one of the above described embodiments, i.e., the super-junction is formed by a transmutation doping process.

Therefore, the super-junction formed by the method according to this embodiment is applicable to various semiconductor devices with various withstand voltages. Thus the doping region of the super junction is well defined, the doping concentration can be precisely controlled, and the doping is in a uniform distribution.

Eighth embodiment

A super-junction semiconductor device is disclosed in this embodiment, wherein a super-junction in the super-junction semiconductor device is the super-junction disclosed by the previous embodiment.

The super-junction may be achieved between the manufacture processes of other structures of the super-junction semiconductor device, so that the super-junction and other structures of the super-junction semiconductor device can share an annealing process. The manufacturing process of the super-junction semiconductor device is further simplified and the manufacture cost is further reduced.

Taking a method for manufacturing a super-junction IGBT (Insulated Gate Bipolar Transistor) as an example, the method includes the following steps:

providing a heavily doped substrate;

growing epitaxially a first-type heavily doped layer on a surface of the heavily doped substrate;

forming a second-type heavily doped region within the first-type heavily doped layer through a transmutation doping process by taking a third mask with a pattern of the second-type heavily doped region, wherein a region other than the second-type heavily doped region is a first-type heavily doped region, and the first-type heavily doped region and the second-type heavily doped region are arranged alternately;

forming a front surface structure including a trap region, an emitter region, a gate, and front metal on the first-type heavily doped layer on which the first-type heavily doped region and the second-type heavily doped region are formed, to accomplish the manufacture of the front surface structure of the super-junction IGBT;

performing annealing treatment to restore electrical properties of the first-type heavily doped layer and to activating the doped ions in the structures such as the trap region and the emitter region, where the temperature for the annealing treatment is between 800 Celsius degree and 900 Celsius degree; and

forming a collector region and back metal on a back surface of the heavily doped substrate to accomplish the manufacture of the back surface structure of the super-junction IGBT.

In addition, the super-junction semiconductor device may also be a semiconductor device having a super-junction VDMOS, a super-junction PIN, or the like.

It should be noted that other charged particles or uncharged particles may also be used as the particles for the radiation in the embodiments not forming part of the the present invention of the present disclosure, as long as the transmutation doping can be achieved. And the radiation energy of the particles is at least able to start a nuclear reaction, and the radiation dose may be pre-calculated as desired. As for other semiconductor materials and the radiation particles, a super-junction may be formed by this method as long as corresponding doping types can be formed. And the formed super-junction may also be used for various semiconductor devices, which are not listed out here.

In addition, a shorter duration is required for some materials and particles than a duration required in a conventional diffusion process. Therefore, the method for manufacturing a super-junction provided by the disclosure may further improve the production efficiency.

In addition, it should be noted that since the nuclear transmutation doping of the semiconductor results in residual radioactivity. Therefore, the lightly doped substrate and the heavily doped substrate requires radiation cooling for a certain duration after the particle radiation, and then can be regarded as a non-radioactive material for subsequent operations.

Drawings in the description are schematic diagrams, and do not represent a real scale. The embodiments of the present disclosure are described herein in a progressive manner, with emphasis on the difference between the embodiments,; hence, for the same or similar parts between the embodiments, one can refer to other embodiments.

The above description of the disclosed embodiments enables those skilled in the art to implement or utilize the present invention as defined in claims 1-9. It will be obvious for those skilled in the art to modify the embodiments in various ways.

**Claims**

1. A method for manufacturing a super-junction, comprising:

   providing (S11) a substrate_doped with a first doping density;
   forming (S12) a p-type region doped with a second doping density within the substrate doped with the first doping density through a transmutation doping process by taking a first mask with a pattern of the p-type region doped with the second doping density, wherein the second doping density is higher than the first doping density;
   forming (S13) an n-type region doped with a third doping density within the substrate doped with the first doping density through a transmutation doping process by taking a second mask with a pattern of the n-type region doped with the third doping density, wherein the third doping density is higher than the first doping density; and
   performing (S14) annealing treatment;
   wherein the forming the p-type region doped with the second doping density within the substrate doped with the first doping density through the transmutation doping process comprises:

      forming (S221) a high-energy photon beam by using a photon source; and
      forming (S222) the p-type region doped with the second doping density within the substrate doped with the first doping density by a nuclear reaction started by particle radiation on the substrate doped with the first doping density by using the high-energy photon beam;
      wherein the energy of the high-energy photon beam is between 17.5 MeV and 22.5 MeV.

2. The method according to claim 1, wherein the substrate doped with the first doping density is made of silicon, silicon carbide, a gallium arsenide, or an indium antimonide.

3. The method according to claim 2, wherein the forming an n-type region doped with the third doping density within the substrate doped with the first doping density through a transmutation doping process comprises:

   forming a neutron beam by using a neutron source; and
   forming an n-type region doped with the third doping density within the substrate doped with the first doping density by a nuclear reaction started by particle radiation on the substrate doped with the first doping density by using the neutron beam.

4. A method for manufacturing a super-junction, comprising:

   providing (S51) a first-type doped substrate;
   forming (S52) a second-type doped region within the first-type doped substrate through a transmutation doping process by taking a third mask with a pattern of the second-type doped region, wherein a region except for the second-type doped region is a first-type doped region; and
   performing (S53) annealing treatment; wherein

      the first-type doped substrate is an n-type doped substrate, and the second-type doped region is a p-type doped region;
      the forming the second-type doped region within the first-type doped substrate through the transmutation doping process comprises:

         forming (S521) a high-energy photon beam by using a photon source; and
         forming (S522) the second-type doped region within the first-type doped substrate by a nuclear reaction started by particle radiation on the first-type doped substrate by using the high-energy photon beam;
         wherein the energy of the high-energy photon beam is between 17.5 MeV and 22.5 MeV.

5. The method according to claim 4, wherein the first-type doped substrate is made of silicon, silicon carbide, diamond, germanium, gallium arsenide, or indium antimonide.

**Patentansprüche**

1. Verfahren zum Herstellen einer Super-Junction, umfassend:

   - Bereitstellen (S11) eines mit einer ersten Dotierdichte dotierten Substrats;
   - Bilden (S12), innerhalb des mit der ersten Dotierdichte dotierten Substrats, einer p-Typ Zone, die mit einer zweiten Dotierdichte dotiert ist, durch einen Transmutationsdotierprozess, indem eine erste Maske mit einem Muster der p-Typ Zone, die mit der zweiten Dotierdichte dotiert ist, genommen wird, wobei die zweite Dotierdichte höher als die erste Dotierdichte ist;
   - Bilden (S13), innerhalb des mit der ersten Dotierdichte dotierten Substrats, einer n-Typ Zone, die mit einer dritten Dotierdichte dotiert ist, durch einen Transmutationsdotierprozess, indem eine zweite Maske mit einem Muster der n-Typ Zone, die mit der dritten Dotierdichte dotiert ist, genommen wird, wobei die dritte Dotierdichte höher als die erste Dotierdichte ist; und
   - Durchführen (S14) einer Temperbehandlung;
   - wobei das Bilden, innerhalb des mit der ersten Dotierdichte dotierten Substrats, der p-Typ Zone, die mit der zweiten Dotierdichte dotiert ist, durch den Transmutationsdotierprozess umfasst:
   - Bilden (S221) eines hochenergetischen Photonenstrahls unter Verwendung einer Photonenquelle; und
   - Bilden (S222), innerhalb des mit der ersten Dotierdichte dotierten Substrats, der p-Typ Zone, die mit der zweiten Dotierdichte dotiert ist, durch eine nukleare Reaktion, die durch eine Teilchenstrahlung auf das mit der ersten Dotierdichte dotierte Substrat unter Verwendung des hochenergetischen Photonenstrahls gestartet wird;
   - wobei die Energie des hochenergetischen Photonenstrahls zwischen 17,5 MeV und 22,5 MeV liegt.

2. Verfahren nach Anspruch 1, wobei das mit der ersten Dotierdichte dotierte Substrat aus Silizium, Siliziumcarbid, einem Galliumarsenid oder einem Indiumantimonid hergestellt ist.

3. Verfahren nach Anspruch 2, wobei das Bilden, innerhalb des mit der ersten Dotierdichte dotierten Substrats, einer n-Typ Zone, die mit der dritten Dotierdichte dotiert ist, durch einen Transmutationsdotierprozess umfasst:

   - Bilden eines Neutronenstrahls unter Verwendung einer Neutronenquelle; und
   - Bilden, innerhalb des mit der ersten Dotierdichte dotierten Substrats, einer n-Typ Zone, die mit der dritten Dotierdichte dotiert ist, durch eine nukleare Reaktion, die durch eine Teilchenstrahlung auf das mit der ersten Dotierdichte dotierte Substrat unter Verwendung des Neutronenstrahls gestartet wird.

4. Verfahren zum Herstellen einer Super-Junction, umfassend:

   - Bereitstellen (S51) eines nach einem ersten Typ dotierten Substrats;
   - Bilden (S52), innerhalb des nach dem ersten Typ dotierten Substrats, einer nach einem zweiten Typ dotierten Zone, durch einen Transmutationsdotierprozess, indem eine dritte Maske mit einem Muster der nach dem zweiten Typ dotierten Zone genommen wird, wobei eine Zone, außer die nach dem zweiten Typ dotierten Zone, eine nach dem ersten Typ dotierte Zone ist; und
   - Durchführen (S53) einer Temperbehandlung; wobei
   - das nach dem ersten Typ dotierte Substrat ein n-Typ dotiertes Substrat ist und die nach dem zweiten Typ dotierte Zone eine p-Typ dotierte Zone ist;
   - das Bilden der nach dem zweiten Typ dotierten Zone innerhalb des nach dem ersten Typ dotierten Substrats durch den Transmutationsdotierprozess umfasst:
   - Bilden (S521) eines hochenergetischen Photonenstrahls unter Verwendung einer Photonenquelle; und
   - Bilden (S522), innerhalb des nach dem ersten Typ dotierten Substrats, der nach dem zweiten Typ dotierten Zone durch eine Kernreaktion, die durch eine Teilchenstrahlung auf das nach dem ersten Typ dotierte Substrat unter Verwendung des hochenergetischen Photonenstrahls gestartet wird;
   - wobei die Energie des hochenergetischen Photonenstrahls zwischen 17,5 MeV und 22,5 MeV liegt.

5. Verfahren nach Anspruch 4, wobei das nach dem ersten Typ dotierte Substrat aus Silizium, Siliziumcarbid, Diamant, Germanium, Galliumarsenid oder Indiumantimonid hergestellt ist.

**Revendications**

1. Procédé de fabrication d'une super-jonction, comprenant les étapes consistant à :

   fournir (S11) un substrat dopé avec une première densité de dopage ;
   former (S12) une région de type P dopée avec une deuxième densité de dopage à l'intérieur du substrat dopé avec la première densité de dopage par un processus de dopage par transmutation en prenant un premier masque avec un motif de la région de type P dopée avec la deuxième densité de dopage, dans lequel la deuxième densité de dopage est supérieure à la première densité de dopage;

former (S13) une région de type N dopée avec une troisième densité de dopage à l'intérieur du substrat dopé avec la première densité de dopage par un processus de dopage par transmutation en prenant un deuxième masque avec un motif de la région de type N dopée avec la troisième densité de dopage, dans lequel la troisième densité de dopage est supérieure à la première densité de dopage; et

effectuer (S14) un traitement de recuit;

dans lequel la formation de la région de type P dopée avec la deuxième densité de dopage à l'intérieur du substrat dopé avec la première densité de dopage par le processus de dopage par transmutation comprend les étapes consistant à:

> former (S221) un faisceau de photons à haute énergie en utilisant une source de photons; et
>
> former (S222) la région de type P dopée avec la deuxième densité de dopage à l'intérieur du substrat dopé avec la première densité de dopage par une réaction nucléaire déclenchée par un rayonnement de particules sur le substrat dopé avec la première densité de dopage en utilisant le faisceau de photons à haute énergie;
>
> dans lequel l'énergie du faisceau de photons à haute énergie est comprise entre 17,5 MeV et 22,5 MeV.

**2.** Procédé selon la revendication 1, dans lequel le substrat dopé avec la première densité de dopage est fait de silicium, de carbure de silicium, d'arséniure de gallium ou d'antimoniure d'indium.

**3.** Procédé selon la revendication 2, dans lequel la formation d'une région de type N dopée avec la troisième densité de dopage à l'intérieur du substrat dopé avec la première densité de dopage par un processus de dopage par transmutation comprend les étapes consistant à:

> former un faisceau de neutrons en utilisant une source de neutrons; et
>
> former une région de type N dopée avec la troisième densité de dopage à l'intérieur du substrat dopé avec la première densité de dopage par une réaction nucléaire déclenchée par un rayonnement de particules sur le substrat dopé avec la première densité de dopage en utilisant le faisceau de neutrons.

**4.** Procédé de fabrication d'une super-jonction, comprenant les étapes consistant à:

> fournir (S51) un substrat dopé de premier type;
>
> former (S52) une région dopée de deuxième type à l'intérieur du substrat dopé de premier type par un processus de dopage par transmutation en prenant un troisième masque avec un motif de la région dopée de deuxième type, dans lequel une région à l'exception de la région dopée de deuxième type est une région dopée de premier type; et
>
> effectuer (S53) un traitement de recuit; dans lequel
>
>> le substrat dopé de premier type est un substrat dopé de type N, et la région dopée de deuxième type est une région dopée de type P;
>>
>> la formation de la région dopée de deuxième type à l'intérieur du substrat dopé de premier type par le processus de dopage par transmutation comprend les étapes consistant à:
>>
>>> former (S521) un faisceau de photons à haute énergie en utilisant une source de photons; et
>>>
>>> former (S522) la région dopée de deuxième type à l'intérieur du substrat dopé de premier type par une réaction nucléaire déclenchée par un rayonnement de particules sur le substrat dopé de premier type en utilisant le faisceau de photons à haute énergie;
>>>
>>> dans lequel l'énergie du faisceau de photons à haute énergie est comprise entre 17,5 MeV et 22,5 MeV.

**5.** Procédé selon la revendication 4, dans lequel le substrat dopé de premier type est fait de silicium, de carbure de silicium, de diamant, de germanium, d'arséniure de gallium ou d'antimoniure d'indium.

P

N

Figure 1

S11
a lightly doped substrate is provided

S12
a p-type heavily doped region is formed
within the lightly doped substrate

S13
an n-type heavily doped region is formed
within the lightly doped substrate

S14
annealing treatment is performed

Figure 2

photon beam

102

10

101

Figure 3

neutron beam

Figure 4

a first-type heavily doped substrate is provided — S31

a second-type heavily doped region is formed within the first-type heavily doped substrate, where the region other than the second-type heavily doped region is a first-type heavily doped region — S32

annealing treatment is performed — S33

Figure 5

photon beam

Figure 6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 0106557 A1

- US 6475864 B1

**Non-patent literature cited in the description**

- APPLICATIONS OF PHOTONUCLEAR REACTIONS. **FINDLAY D J S ED-BRAUCHER REGIS et al.** NUCLEAR INSTRUMENTS & METHODS IN PHYSICS RESEARCH. SECTION B: BEAM INTERACTIONS WITH MATERIALS AND ATOMS. ELSEVIER BV, 03 April 1990, vol. B50, 314-320